# EUROPEAN PATENT APPLICATION

(11) **EP 2 292 555 A1**
(43) Date of publication of application: **09.03.2011**
(21) Application number: 09746679.1
(22) Date of filing: 15.05.2009
(51) Int. Cl.: C01B 9/08, C30B 15/00, C30B 15/08, C30B 29/12, G02B 1/02

(54) **PRETREATED METAL FLUORIDES AND PROCESS FOR PRODUCTION OF FLUORIDE CRYSTALS**

(30) Priority: 16.05.2008 JP 2008129974
(71) Applicant: Tokuyama Corporation, Shunan-shi, Yamaguchi 745-8648 (JP); National Institute of Advanced Industrial Science and Technology, Tokyo 100-8921 (JP)
(72) Inventor: ISHIZU, Sumito, Shunan-shi Yamaguchi 745-8648 (JP); SEKIYA, Akira, Tsukuba-shi Ibaraki 305-8565 (JP); FUKUDA, Kentaro, Shunan-shi Yamaguchi 745-8648 (JP); SUYAMA, Toshihisa, Shunan-shi Yamaguchi 745-8648 (JP)
(74) Representative: Duckworth, Timothy John
(86) International application number: PCT/JP2009/059091
(87) International publication number: WO 2009/139473

(57) **Abstract**

[Problem] To provide a method of producing a pretreated metal fluoride containing impurities such as oxygen in decreased amounts and a fluoride crystal containing impurities such as oxygen in decreased amounts and having excellent optical properties such as transparency.

[Means for Solution] A metal fluoride is heated in a temperature range of not lower than 300° K but not higher than 1780° K in the co-presence of a carbonyl fluoride of an amount of not less than 1/100 mol per mol of the metal fluoride to thereby obtain a pretreated metal fluoride while removing oxygen and water from the starting metal fluoride and from the interior of the production furnace. Further, the pretreated metal fluoride as a starting material is heated and melted, and a fluoride crystal of a high quality is obtained from the obtained melt by a crystal growing method such as a melt pull-up method or a melt pull-down method.

## Description

### Technical Field:

This invention relates to a method of producing pretreated metal fluorides and a method of producing fluoride crystals. More specifically, the invention relates to pretreated metal fluorides and to highly pure fluoride crystals containing impurities such as oxygen in decreased amounts which are useful as optical materials.

### Background Art:

Fluoride crystals such as of barium yttrium fluoride and lithium yttrium fluoride have high transmittance over a wide wavelength band and remain chemically stable, and, therefore, are finding demands as optical materials for light-emitting elements, various devices that use laser, and cameras, and as lenses and window materials.

So far, the fluoride crystals had been produced by a method in which a metal fluoride which is a starting material is once melted at a high temperature, and a single crystal is grown from the melt thereof. However, the fluoride crystal easily reacts with impurities such as oxygen, water, etc., and its properties such as transparency tend to be greatly deteriorated due to such impurities.

In order to prevent adverse effects stemming from such impurities as oxygen, water, etc., there have been proposed methods of removing impurities such as oxygen, water, etc. by adding a solid scavenger such as lead fluoride (see non-patent document 1) or cadmium fluoride (see non-patent document 2). If the solid scavenger is used, however, the scavenger itself remains in the crystal. Therefore, optical properties of the crystal are often deteriorated being affected by the solid scavenger.

To prevent the effect of the solid scavenger remaining in the crystal, there has been proposed a method that uses a gaseous scavenger such as methane tetrafluoride (see patent document 1). The gaseous scavenger does not remain in the crystal. In a high-temperature atmosphere at the time of obtaining a singe crystal by growing the crystal from the melt of the metal fluoride, however, the gaseous scavenger undergoes the thermal decomposition to form soot-like foreign matter which makes it difficult to the grow crystal.

If the gaseous scavenger is used at a temperature lower than the temperature at which it thermally decomposes, on the other hand, the gaseous scavenger does not exhibit its reactivity to a sufficient degree. Therefore, it becomes difficult to effectively remove impurities such as oxygen, water, etc. from the metal fluoride. Besides, methane tetrafluoride is a gas that remains very stable in the atmosphere and exhibits a stronger greenhouse effect that invites global warming than carbon dioxide for extended periods of time. Therefore, a measure must be taken such as introducing a facility for decomposing the gas requiring tremendously large amounts of energy and arousing a problem of increased cost of running.

### Prior Art Documents:

### Patent Documents:

Patent document 1: JP-A-2005-200256

### Non-patent documents:

Non-patent document 1: Stockbarger, J. Opt. Am. 39, 1949
Non-patent document 2: Radzhabov and Figura, Phys. Stat. Sol. (b) 136, 1986

### Outline of the Invention:

### Problems that the Invention is to Solve:

The object of the present invention is to provide a method of producing a pretreated metal fluoride containing impurities such as oxygen in decreased amounts and a method of producing a fluoride crystal containing impurities such as oxygen in decreased amounts and having excellent optical properties.

In view of the above problem, the present inventors have conducted a keen study concerning a scavenger that does not remain in the metal fluoride and that exhibits the effect for removing oxygen to a sufficient degree at a temperature lower than its decomposition temperature. As a result, the inventors have discovered that a carbonyl fluoride which is a gas at normal temperature has the effect of particularly excellently removing oxygen even at temperatures lower than its decomposition temperature.

The inventors have further discovered that by using the carbonyl fluoride as a scavenger and by heating a metal fluoride in the co-presence of the carbonyl fluoride, there is obtained a pretreated metal fluoride containing impurities such as oxygen in decreased amounts.

Further, by using the above pretreated metal fluoride as a molten starting material and by growing a crystal, as required, in the co-presence of a gaseous scavenger or a carbonyl fluoride, the present inventors have discovered that there is obtained a fluoride crystal containing impurities such as oxygen in decreased amounts and having excellent optical properties and have, thus, completed the invention.

### Means for Solving the Problems:

According to the present invention, there is provided a method of producing a pretreated metal fluoride by heating a metal fluoride in the co-presence of a carbonyl fluoride. In the method of producing a pretreated metal fluoride, it is preferred that:
(1) The heating temperature is not lower than 300° K but is not higher than 1780° K; and
(2) The amount of the carbonyl fluoride to be made co-present is not less than 1/100 mol per mol of the metal fluoride.
   According to the present invention, there is, further, provided a method of producing a fluoride crystal by heating and melting a metal fluoride in the co-presence of a carbonyl fluoride to obtain a melt thereof, and growing a crystal from the melt.
   According to the present invention, there is, further, provided a method of producing a fluoride crystal, comprising the step of obtaining a pretreated metal fluoride by heating a metal fluoride in the co-presence of a carbonyl fluoride, and the step of growing a crystal from the pretreated metal fluoride.
In the method of producing a fluoride crystal, it is preferred that:
(1) In the step of obtaining the pretreated metal fluoride, the heating temperature is not lower than 300° K but is not higher than 1780° K;
(2) In the step of obtaining the pretreated metal fluoride, the amount of the carbonyl fluoride to be made co-present is not less than 1/100 mol per mol of the metal fluoride;
(3) In the step of growing the crystal, the crystal is grown by a melt pull-up method in which a seed crystal is contacted to the upper end of the melt of the pretreated metal fluoride and is pulled up or by a melt pull-down method in which a pulling-down rod is contacted to the lower end of the melt of the pretreated metal fluoride and is pulled down; and
(4) In the step of growing the crystal, the crystal is grown from the melt in the co-presence of a gaseous scavenger.

### Effects of the Invention:

According to the present invention, there are provided a method of producing a pretreated metal fluoride containing impurities such as oxygen in decreased amounts and a method of producing a fluoride crystal containing impurities such as oxygen in decreased amounts and having excellent optical properties such as transparency.
The pretreated metal fluoride obtained by the production method of the present invention serves as a material suited for use as a molten starting material for growing a fluoride crystal. The obtained fluoride crystal serves as an optical material of a high quality that can be favorably used in the fields of light-emitting elements, various devices that use laser, cameras, lenses and window materials.
Further, the carbonyl fluoride used in the invention can be easily removed, and is not likely to remain as impurities in the produced fluoride crystal or in the pretreated metal fluoride. Therefore, fluoride crystal of a high quality can be produced.
Further, the carbonyl fluoride used in the invention easily undergoes the hydrolysis upon contacting with water and can, therefore, be easily turned into a harmless material. Therefore, no large-scale gas-decomposing apparatus is required after the use offering advantage in regard to the cost of running when operated on an industrial scale.

### Brief Description of the Drawings:

[Fig. 1] is a schematic view of an apparatus for producing a crystal based on the melt pull-down method.
[Fig. 2] is a schematic view of an apparatus for measuring transmission spectra.
[Fig. 3] is a diagram showing transmission spectra of barium yttrium fluoride crystals of when the heating temperature is varied (Examples 1 to 6, Comparative Examples 1 and 2).
[Fig. 4] is a diagram showing transmission spectra of barium yttrium fluoride crystals of when the heating temperature is varied (Examples 1, 7 to 10, Comparative Examples 1 and 2).
[Fig. 5] is a diagram showing transmission spectra of barium yttrium fluoride crystals of when the mol ratio of the carbonyl fluoride to the metal fluoride is varied (Examples 8, 11 to 14).
[Fig. 6] is a diagram of transmission spectra of a barium yttrium fluoride crystal grown in the absence of gaseous scavenger by purging the pretreated metal fluoride with the argon gas without being opened to the atmosphere and of a barium yttrium fluoride crystal grown by opening the pretreated metal fluoride to the atmosphere and, thereafter, in the presence of methane tetrafluoride (Examples 8 and 15).
[Fig. 7] is a diagram of transmission spectra of a barium yttrium fluoride crystal grown in the absence of gaseous scavenger by purging the pretreated metal fluoride with the argon gas without being opened to the atmosphere and of a barium yttrium fluoride crystal grown in the presence of methane tetrafluoride by purging the pretreated metal fluoride with the argon gas containing methane tetrafluoride as the gaseous scavenger without being opened to the atmosphere (Examples 8 and 16).
[Fig. 8] is a diagram of transmission spectra of a barium yttrium fluoride crystal grown in the absence of gaseous scavenger by purging the pretreated metal fluoride with the argon gas without being opened to the atmosphere and of a barium yttrium fluoride crystal grown in the pretreating atmosphere in the presence of carbonyl fluoride as the gaseous scavenger without being purged with gas (Examples 8 and 17).
[Fig. 9] is a diagram of transmission spectra of lithium yttrium fluoride crystals doped with cerium (Example 18, Comparative Example 3).
[Fig. 10] is a photograph of a barium yttrium crystal obtained in Example 1 after polished.
[Fig. 11] includes an SEM photograph of a barium yttrium crystal obtained in Example 1 and the results of EDS observation.
[Fig. 12] is a photograph of a barium yttrium crystal obtained in Comparative Example 2 after polished.
[Fig. 13] includes an SEM photograph of a barium yttrium crystal obtained in Comparative Example 2 after polished and the results of EDS observation.

### Description of Reference Numerals:

- 1: after-heater
- 2: heater
- 3: heat-insulating material
- 4: stage
- 5: crucible
- 6: chamber
- 7: high-frequency coil
- 8: pulling-down rod
- 9: sample for measuring spectra
- 10: deuterium lamp
- 11: monochromator for transmitting light
- 12: photomultiplier tube

### Mode for Carrying Out the Invention:

In the method of producing a pretreated metal fluoride of the present invention, there is no particular limitation on the metal fluoride, and there can be used any metal fluoride.

Concrete examples of the metal fluoride include lithium fluoride, sodium fluoride, rubidium fluoride, magnesium fluoride, calcium fluoride, strontium fluoride, aluminum fluoride, zinc fluoride, yttrium fluoride, zirconium fluoride, hafnium fluoride, tantalum fluoride, chromium fluoride, iron fluoride, cobalt fluoride, nickel fluoride, copper fluoride, silver fluoride, mercury fluoride, tin fluoride, cesium fluoride, indium fluoride, bismuth fluoride, lead fluoride, thallium fluoride, barium fluoride, lanthanum fluoride, cerium fluoride, praseodymium fluoride, neodymium fluoride, samarium fluoride, europium fluoride, gadolinium fluoride, terbium fluoride, dysprosium fluoride, holmium fluoride, erbium fluoride, thulium fluoride, ytterbium fluoride, ruthenium fluoride, and mixtures thereof.

As the metal fluoride, there can be used any metal fluoride placed in the market without limitation. However, some metal fluorides placed in the market may be adsorbing water in large amounts. It is, therefore, desired to heat-treat the metal fluoride in high degree of vacuum to dry it prior to conducting the pretreatment with the carbonyl fluoride of the invention.

The carbonyl fluoride essential in the present invention has a property to react with water so as to be decomposed into carbon dioxide and hydrogen fluoride or to react with oxygen so as to be decomposed into carbon dioxide and fluorine gas according to the reaction formulas described below. By utilizing these properties, it is allowed to remove oxygen and water contained in the metal fluoride. It is, further, possible to remove oxygen and water remaining in the apparatus used at the time of heat-treating the metal fluoride in the co-presence of carbonyl fluoride.

COF₂ + H₂O → CO₂ + 2HF

2COF₂ + O₂ → 2CO₂ + 2F₂

Upon coming in contact with water, further, the carbonyl fluoride is easily hydrolyzed. Through the treatment by using a scrubber or the like, therefore, the carbonyl fluoride can be easily turned to be harmless.

Unlike such a scavenger as lead fluoride or ?gadolinium? fluoride, further, the carbonyl fluoride is a gas at normal temperature. Upon evacuating the interior of the apparatus for heat-treating the metal fluoride or the interior of the apparatus for growing crystals, therefore, the carbonyl fluoride can be easily removed from the fluoride crystal or from the pretreated metal fluoride. Therefore, the carbonyl fluoride does not remain as impurities in the produced fluoride crystal or in the pretreated metal fluoride. Accordingly, the fluoride crystal of a high quality can be produced.

The carbonyl fluoride can be produced by any known production method such as a method that fluorinates phosgene or a method that fluorinates carbon monoxide. The carbonyl fluorides produced by such methods have been widely placed in the market and are easily available.
The carbonyl fluoride may often contain, as impurities, fluorohydrocarbons other than the carbonyl fluoride. Such impurities may often form soot-like foreign matter upon being thermally decomposed under a heated condition. It is, therefore, desired to remove impurities in advance by such an operation as distillation. Though there is no particular limitation, it is desired that the carbonyl fluoride gas has a purity of not lower than 90% by volume and, particularly preferably, not lower than 99% by volume.

As a method of making the metal fluoride present together with the carbonyl fluoride, there can be preferably employed a method that hermetically contains the metal fluoride and the carbonyl fluoride in the same apparatus or a method that flows the carbonyl fluoride at a predetermined flow rate into the apparatus that contains the metal fluoride so as to be contacted thereto.

As a method of heating the metal fluoride in the co-presence of carbonyl fluoride, there can be used any existing heating method such as resistance heating, induction heating, infrared heating, arc heating, electron beam heating or laser heating without limitation. Among them, the resistance heating and induction heating do not require any particular condition for introducing the apparatus, enable relatively inexpensive apparatus to be employed, and are desirable from the standpoint of general applicability and economy.

It is desired that the apparatus for heat-treating the metal fluoride in the co-presence of carbonyl fluoride has a closed chamber without permitting the atmosphere in the apparatus to leak to the exterior and, further, has a vacuum exhaust system and a line for introducing gas. Concretely, there can be used an apparatus that is used in the crucible-lowering method, melt pull-up method, melt pull-down method and in the annealing operation though not limited thereto only.

There is no particular limitation on the heating temperature. According to the study by the present inventors, however, the reactivity of the carbonyl fluoride increases with an increase in the heating temperature, and impurities such as oxygen and water can be removed from the metal fluoride in short periods of time. If the heating temperature is too high, on the other hand, the carbonyl fluoride undergoes the thermal decomposition according to, for example, the following formula to form soot-like foreign matter often making it difficult to control the process. Besides, the carbonyl fluoride is a corrosive gas, and elevating its temperature too high is not desirable from the standpoint of maintenance and management of the apparatus.

2COF₂ → CO₂ + C + 2F₂

On account of the foregoing reasons, the heating temperature is desirably 300 to 1780° K and, particularly desirably, 400 to 900° K.

There is no particular limitation on the heating time which, therefore, may be determined by taking the above heating temperature and the carbonyl fluoride concentration described below into account. Desirably, however, the heating time is not shorter than 10 minutes and, more desirably, not shorter than one hour so that the carbonyl fluoride fully reacts with impurities such as oxygen and water. From the standpoint of productivity, further, the heating time is within 24 hours and, desirably, within 6 hours.

In the present invention, the higher the concentration of the carbonyl fluoride, the shorter the time for the pretreatment. It is, therefore, desired that the amount of the carbonyl fluoride to be made co-present is not less than 1/100 mol and, particularly desirably, not less than a mol per mol of the metal fluoride that is used. On the other hand, there is no upper limit on the amount of the carbonyl fluoride. However, the carbonyl fluoride is an expensive gas and is, further, highly corrosive making the maintenance of the apparatus difficult. It is, therefore, desired that the amount of the carbonyl fluoride that is to be made co-present is not more than 50 mols per mol of the metal fluoride that is used.
When a plurality of metal fluorides are simultaneously pretreated in order to produce a starting material for the production of a composite fluoride crystal, the amount (concentration) of the carbonyl fluoride is determined based on the sum of mol numbers of the metal fluorides. Further, the metal fluoride produced through the pretreatment is such that the starting metal fluorides are present being simply mixed together if the heating temperature of the pretreatment is low. If the heating temperature is higher than a melting point of the object composite fluoride crystal, however, the starting metal fluorides are melted, and partly or wholly turn into a pretreated composite metal fluoride having the same composition as the composite fluoride crystal.

To adjust the concentration of the carbonyl fluoride during the pretreatment, there can be used an inert gas such as nitrogen, helium, argon or neon together with the carbonyl fluoride. The gas may be used being mixed with the carbonyl fluoride in advance. Or, the gases may be separately introduced into the apparatus that heat-treats the metal fluoride, and may be mixed together therein.

The carbonyl fluoride is also useful as a scavenger for crystal growth process by being made co-present at the process.

By using the pretreated metal fluoride obtained by heating the metal fluoride in the co-presence of the carbonyl fluoride as the starting material for growing crystal, it is made possible to obtain a fluoride crystal of a high quality.

There is no particular limitation on the method of growing a fluoride crystal from the metal fluoride, and there can be used any known growing method without limitation, such as growing crystal from the melt of a metal fluoride that will be described later, a method of growth from a solution like crystallization by adding a poor solvent, or a method of growth from the vapor phase like chemical vapor deposition. Among them, the method of growing a crystal from the melt is desired from the standpoint of obtaining a large crystal compared to those of other methods and the cost of production.

As the method of heating and melting the metal fluoride to obtain a melt and growing a crystal from the melt, there can be used any known method of growing a crystal without limitation.

Concretely, there can be exemplified a crucible lowering method in which a melt of a starting material for producing a single crystal in a crucible is cooled while being gradually lowered together with the crucible to grow a single crystal in the crucible, a melt pull-up method in which a seed crystal of a desired single crystal is contacted to the surface of a melt of a starting material in the crucible, and the seed crystal is gradually pulled up from the hot zone and cooled to grow the single crystal on the lower side of the seed crystal, and a micro pulling-down method (melt pull-down method) in which a melt is dripped out through a hole formed in the bottom of a crucible, and the melt that is dripped out is pulled down to grow a single crystal.

Among them, the melt pull-down method makes it possible to grow the crystal within a period of time shorter than that of the crucible lowering method or the melt pull-up method and, further, offers such an advantage that, when the doping is conducted, the additives can be doped at higher concentrations. Therefore, the melt pull-down method can be favorably used for the present invention.

As the pulling-down rod in the melt pull-down method, there can be used a seed crystal comprising a desired single crystal. There can be, further, used known metals such as tungsten-rhenium (hereinafter W-Re) and platinum. Among them, W-Re offers such advantages as high corrosion resistance at high temperatures maintaining a suitable degree of rigidity and is preferred from the standpoint of a high general applicability.

In the present invention, there is no particular limitation on the fluoride crystal that is to be produced and concrete examples of the fluoride crystal include lithium fluoride, sodium fluoride, rubidium fluoride, magnesium fluoride, calcium fluoride, strontium fluoride, aluminum fluoride, zinc fluoride, yttrium fluoride, lead fluoride, thallium fluoride, barium fluoride, lanthanum fluoride, cerium fluoride, praseodymium fluoride, neodymium fluoride, barium lithium fluoride, magnesium potassium fluoride, aluminum lithium fluoride, calcium strontium fluoride, cesium calcium fluoride, lithium calcium aluminum fluoride, lithium strontium aluminum fluoride, lithium yttrium fluoride, barium yttrium fluoride, potassium yttrium fluoride, lithium lutetium fluoride, barium erbium fluoride, barium thulium fluoride and barium lutetium fluoride.

When the composition of a melt obtained by melting the pretreated metal fluoride which is the starting material is in agreement with the composition of the crystal that is really obtained, it is said that the melt has a congruent composition. It often happens that the composition of a melt obtained by melting the starting material is not in agreement with the composition of the crystal that is really obtained. In such a case, it is said that the melt has an incongruent composition. The present invention can be put to work irrespective of when the melt has a congruent composition or an incongruent composition.

When the desired fluoride crystal is a composite fluoride crystal and is grown from a melt of a congruent composition, a plurality of pretreated metal fluorides may be determined in advance and may be fed so that the melt thereof acquires a stoichiometrical composition. When, for example, a barium yttrium fluoride crystal is to be grown, a mol of barium fluoride and 2 moles of yttrium fluoride are fed and melted. Or, at the time of producing the pretreated metal fluoride as described above, the pretreatment may be conducted at a temperature higher than a melting point of the desired composite fluoride crystal to obtain a pretreated composite metal fluoride having the same composition as that of the object crystal.
In the case of the incongruent composition, the pretreated metal fluoride is determined, fed and is melted according to a phase diagram of the fluoride crystal so as to acquire a suitable composition. From this melt, a crystal is grown in the same manner as from the melt of the congruent composition to thereby obtain a fluoride crystal of the desired composition.

According to the invention, additives may be added to have the object fluoride crystal emit light or to improve the crystallinity of the object fluoride crystal. The additives may be cerium fluoride, praseodymium fluoride, neodymium fluoride, samarium fluoride, europium fluoride, gadolinium fluoride, terbium fluoride, dysprosium fluoride, holmium fluoride, erbium fluoride, thulium fluoride, ytterbium fluoride, lithium fluoride, sodium fluoride and lead fluoride though not limited thereto only.

Generally, the starting material of fluoride crystal (pretreated metal fluoride) is charged in a predetermined amount into the crucible and is melted therein so as to be used for growing crystal. When the crystal is grown from the incongruent melt or when the crystal is grown by adding additives thereto, however, the composition of the melt may often vary as the crystal grows. In order to suppress the composition from varying or to grow the crystal of a large size, the crystal may be grown while adding the starting material to the melt.

In the step of growing the crystal, the crystal can be grown in an inert gas atmosphere such as of nitrogen, helium, argon or neon. According to a preferred embodiment, further, the inert gas can be used being blended with a known gaseous scavenger such as perfluorocompound (PFC) like methane tetrafluoride, ethane hexafluoride or propane octafluoride; a hydrofluorocarbon like methane trifluoride (HFC23) or 1,1,1,2-tetrafluoroethane (HFC-134a); or fluorine-contained olefin like hexafluoropropylene or 2,3,3,3-tetrafluoropropylene (HFO-1234yf). Further, the carbonyl fluoride can be used as the gaseous scavenger.

In producing the fluoride crystal according to the invention, an annealing operation may be conducted after the crystal has been produced in order to remove defects from the crystal caused by thermal distortion. The apparatus used for the annealing operation desirably has a function for controlling the temperature and is capable of controlling the atmosphere in the apparatus. As the atmosphere at the time of annealing, there may be used an atmosphere containing carbonyl fluoride.

Described below are the method of producing the pretreated metal fluoride using the carbonyl fluoride and the method of producing the fluoride crystal according to the invention with reference to the case of the melt pull-down method.

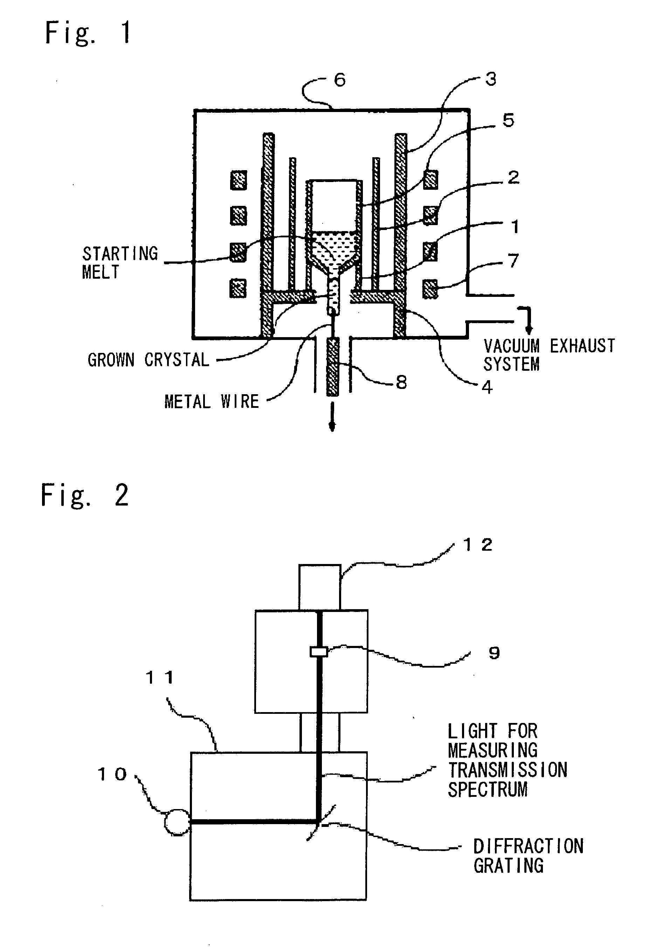

The melt pull-down method is a method of producing a crystal by using an apparatus as shown in Fig. 1 and pulling down a starting melt from a hole formed in the bottom portion of a crucible 5. As materials of an after-heater 1, heater 2, heat-insulating material 3, stage 4 and crucible 5, there are, usually, used graphite, glassy graphite and silicon carbide-deposited graphite. However, there can be also used any other materials without problem.

First, the starting material of a predetermined amount is put into the crucible 5 having a hole formed in the bottom portion thereof. Though there is no particular limitation, it is desired that the hole formed in the bottom portion of the crucible has a cylindrical shape of a diameter of 0.5 to 4 mm and a length of 0.1 to 2 mm. Though there is no particular limitation on the purity of the starting material, it is desired to use metal fluorides having purities of not lower than 99.99% by volume, respectively.

Next, the crucible 5 filled with the metal fluorides, the after-heater 1, the heater 2, the heat-insulating material 3 and the stage 4 are set as shown in Fig. 1. By using a vacuum system, the interior of a chamber 6 is evacuated. By using a high-frequency coil 7, at the same time, the interior of the crucible is heated, desirably, up to 350 to 1000° K. This is to remove the water adhered to the furnace, carbon materials and metal fluorides. It is, further, desired to continue the evacuation until the pressure becomes 1.0 x 10⁻³ Pa or lower.

The carbonyl fluoride is introduced into the chamber 6 alone or being mixed with an inert gas such as high purity argon. After the introduction, the interior of the crucible is heated desirably up to a temperature of 400° K to 900° K by using the high-frequency coil 7. In this step, the oxygen and water contained in the metal fluorides can be removed. It is, further, possible to remove oxygen and water remaining in the apparatus that heat-treats the metal fluorides.

By using the vacuum system, the gas introduced into the furnace is evacuated to remove the carbonyl fluoride out of the furnace. Here, it is desired to conduct the evacuation until the pressure becomes 1.0 x 10⁻³ Pa or less. Thereafter, the inert gas such as of argon of a highly pure form is introduced into the furnace to purge. The purging operation is conducted a total of two times.

Through the above operation, a pretreated metal fluoride is produced. A crystal is then grown by using the pretreated metal fluoride as a starting material.

After having conducted the gas-purging operation, the starting material is heated by the high-frequency coil 7 and is melted. The melt of the starting material is pulled down through the hole in the bottom portion of the crucible to start growing the crystal. As the atmosphere in the furnace at the time of growing the crystal, there can be used, in addition to the inert gas such as highly pure argon, a gaseous scavenger such as carbonyl fluoride or methane tetrafluoride in one kind or being mixed together at any ratio. Here, the metal fluoride, usually, has a very large contact angle to the carbon, and the melt does not drop out from the hole at the bottom of the crucible unless some particular means is provided. The present inventors have attempted to attach a wire of W-Re alloy to an end of a pull-down rod, insert the W-Re alloy wire in the crucible through the hole formed at the bottom of the crucible so that the melt adheres to the W-Re alloy wire, and pull down the melt together with the W-Re alloy wire, and have thus made it possible to grow the crystal.

After having been pulled out by using the W-Re alloy wire, the melt is pulled down continuously at a predetermined pull-down speed to obtain the desired fluoride crystal. Though not particularly limited, the pull-down speed is desirably in a range of 0.5 to 10 mm/hr.

The obtained fluoride crystal is basically a single crystal. The crystal has a favorable workability and can be used being easily worked into any desired shape. The working can be done by using a known cutting machine such as blade saw or wire saw, by using a grinding machine or by using a polishing machine without any limitation.

The obtained fluoride crystal is machined into a desired shape and is put to any use, such as vacuum ultraviolet light-emitting element, laser, etc.

### EXAMPLES

The invention will now be concretely described with reference to Examples to which only, however, the invention is in no way limited. Further, it does not mean that combinations of features described in Examples are all necessary for solving the problems of the invention.

### Example 1.

### (Preparation for growth)

A crystal of barium yttrium fluoride was produced by using an apparatus for producing crystal shown in Fig. 1. As starting materials, there were used barium fluoride and yttrium fluoride having a purity of 99.99% by volume. The after-heater 1, heater 2, heat-insulating member 3, stage 4 and crucible 5 were made of highly pure carbon, and the hole formed in the bottom portion of the crucible possessed a cylindrical shape of a diameter of 2.0 mm and a length of 0.5 mm.
First, there were weighed 0.42 g of barium fluoride and 0.69 g of yttrium fluoride, which were mixed well and were put into the crucible 5. The crucible 5 filled with the starting materials was set onto an upper part of the after-heater 1. Thereafter, the heater 2 and the heat-insulating member 3 were set successively to surround them.

### (Heat-drying treatment in the apparatus)

Next, by using a vacuum exhaust system comprising an oil rotary pump and an oil diffusion pump, the interior of the chamber 6 was evacuated down to 5.0 × 10⁻⁴ Pa. At the same time, heating was conducted by using the high-frequency coil 7 so that the temperature in the crucible was 570° K during the evacuation.

### (Step of heating the metal fluorides in the co-presence of carbonyl fluoride)

A mixed gas of 95% by volume of argon and 5% by volume of carbonyl fluoride was introduced into the chamber 6. By using the high-frequency coil 7, the output of the high-frequency heating coil was,so adjusted that the heating temperature was 790° K while measuring the temperature at the bottom portion of the crucible. The pressure in the chamber 6 after substituted with the mixed gas was set to be the atmospheric pressure and in this state, the heating was continued for 30 minutes.

### (Exhausting the carbonyl fluoride and introducing the atmosphere gas for growing crystal)

Next, the evacuation was conducted while continuing the heating by using the high-frequency heating coil and, further, an argon gas was introduced into the chamber 6 to purge. The pressure in the chamber 6 after purged with the argon was set to be the atmospheric pressure. The same operation was conducted twice.

### (Step of growing crystal)

By using the high-frequency heating coil 7, the starting materials were melted by being heated up to the melting point of the barium yttrium fluoride. However, no starting melt was recognized to have oozed out from the hole in the bottom portion of the crucible 5. Therefore, the temperature of the starting melt was gradually elevated by adjusting the output of high-frequency waves, and the W-Re wire attached to an end of the pull-down rod 8 was inserted in the hole and was pulled down repetitively. The starting melt could now be drawn out from the hole. The output of high-frequency waves was fixed to hold the temperature of this moment, and the starting melt was pulled down to start crystallization. The melt was pulled down continuously for 14 hours at a rate of 3 mm/hr to finally obtain a crystal of a diameter of 2.1 mm and a length of 40 mm. From the powder X-ray diffraction analysis, it was confirmed that the crystal was that of barium yttrium fluoride. The following examples were also confirmed in the same manner.

### (Measuring the transmission spectra)

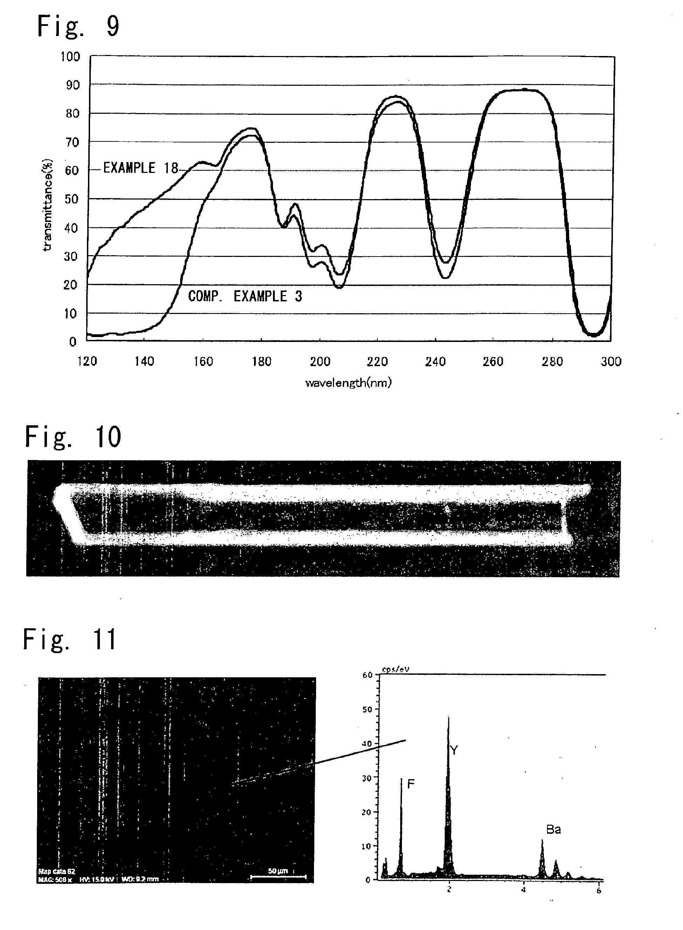

By using a blade saw equipped with a diamond cutting grind stone, the obtained crystal was cut into a length of about 15 mm, and the side surfaces thereof were ground into a shape of a length of 15 mm, a width of 2 mm and a thickness of 1 mm to use the thus worked article as a sample for measuring spectra. By using a measuring apparatus shown in Fig. 2, measurement was taken according to a procedure described below at room temperature. Fig. 10 is a photograph of the sample for measuring spectra.

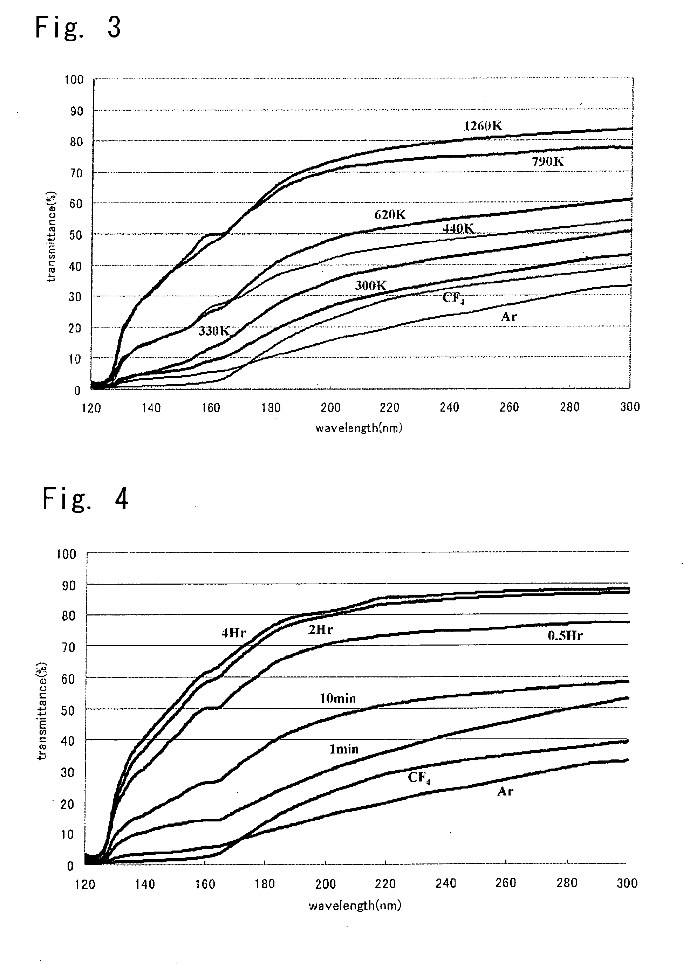

A sample 9 for measuring spectra was set to a predetermined position in the measuring apparatus, and the whole interior of the apparatus was purged with the nitrogen gas. Light transmitted from a deuterium lamp 10 which is a source of light for transmission was separated by a transmission light spectroscope 11 (ultraviolet spectroscope, Model KV201, manufactured by Bunkokeiki Co.), applied onto the sample 9 for measuring spectra, and light transmitted from the sample was recorded by a photoelectron multiplier tube 13 to obtain spectra of transmission. The results were as shown in Table 1 and Fig. 3. The obtained sample was, further, observed by using SEM-3400N manufactured by Hitachi, Ltd. The results were as shown in Fig. 11.

### Example 2.

A crystal was grown in the same manner as in Example 1 but setting the temperature to be 620° K at the bottom portion of the crucible after a mixed gas of 95% by volume of argon and 5% by volume of carbonyl fluoride was introduced in the step of heating in the co-presence of carbonyl fluoride. A sample for measuring the spectra was thus prepared and was measured for its ultraviolet ray transmission factor in vacuum. The result was as shown in Table 1 and Fig. 3.

### Example 3.

A crystal was grown in the same manner as in Example 1 but setting the temperature to be 440° K at the bottom portion of the crucible after a mixed gas of 95% by volume of argon and 5% by volume of carbonyl fluoride was introduced in the step of heating in the co-presence of carbonyl fluoride. A sample for measuring the spectra was thus prepared and was measured for its ultraviolet ray transmission factor in vacuum. The result was as shown in Table 1 and Fig. 3.

### Example 4.

A crystal was grown in the same manner as in Example 1 but setting the temperature to be 350° K at the bottom portion of the crucible after a mixed gas of 95% by volume of argon and 5% by volume of carbonyl fluoride was introduced in the step of heating in the co-presence of carbonyl fluoride. A sample for measuring the spectra was thus prepared and was measured for its ultraviolet ray transmission factor in vacuum. The result was as shown in Table 1 and Fig. 3.

### Example 5.

A crystal was grown in the same manner as in Example 1 but setting the temperature to be 300° K at the bottom portion of the crucible after a mixed gas of 95% by volume of argon and 5% by volume of carbonyl fluoride was introduced in the step of heating in the co-presence of carbonyl fluoride. A sample for measuring the spectra was thus prepared and was measured for its ultraviolet ray transmission factor in vacuum. The result was as shown in Table 1 and Fig. 3.

### Example 6.

After evacuated in the same manner as in Example 1, a mixed gas of 95% by volume of argon and 5% by volume of carbonyl fluoride was introduced, and heating was conducted until the temperature was 1260° K at the bottom portion of the crucible to melt the starting materials. Thereafter, the melt was drawn down in the same manner as in Example 1 to grow the crystal. A sample for measuring the spectra was thus prepared and was measured for its ultraviolet ray transmission factor in vacuum. The result was as shown in Table 1 and Fig. 3.

### Example 7.

A crystal was grown in the same manner as in Example 1 but setting the heating time to be 4 hours after a mixed gas of 95% by volume of argon and 5% by volume of carbonyl fluoride was introduced in the step of heating in the co-presence of carbonyl fluoride. A sample for measuring the spectra was thus prepared and was measured for its ultraviolet ray transmission factor in vacuum. The result was as shown in Table 1 and Fig. 4.

### Example 8.

A crystal was grown in the same manner as in Example 1 but setting the heating time to be 2 hours after a mixed gas of 95% by volume of argon and 5% by volume of carbonyl fluoride was introduced in the step of heating in the co-presence of carbonyl fluoride. A sample for measuring the spectra was thus prepared and was measured for its ultraviolet ray transmission factor in vacuum. The result was as shown in Table 1 and Fig. 4.

### Example 9.

A crystal was grown in the same manner as in Example 1 but setting the heating time to be 10 minutes after a mixed gas of 95% by volume of argon and 5% by volume of carbonyl fluoride was introduced in the step of heating in the co-presence of carbonyl fluoride. A sample for measuring the spectra was thus prepared and was measured for its ultraviolet ray transmission factor in vacuum. The result was as shown in Table 1 and Fig. 4.

### Example 10.

A crystal was grown in the same manner as in Example 1 but setting the heating time to be 1 minute after a mixed gas of 95% by volume of argon and 5% by volume of carbonyl fluoride was introduced in the step of heating in the co-presence of carbonyl fluoride. A sample for measuring the spectra was thus prepared and was measured for its ultraviolet ray transmission factor in vacuum. The result was as shown in Table 1 and Fig. 4.

### Example 11.

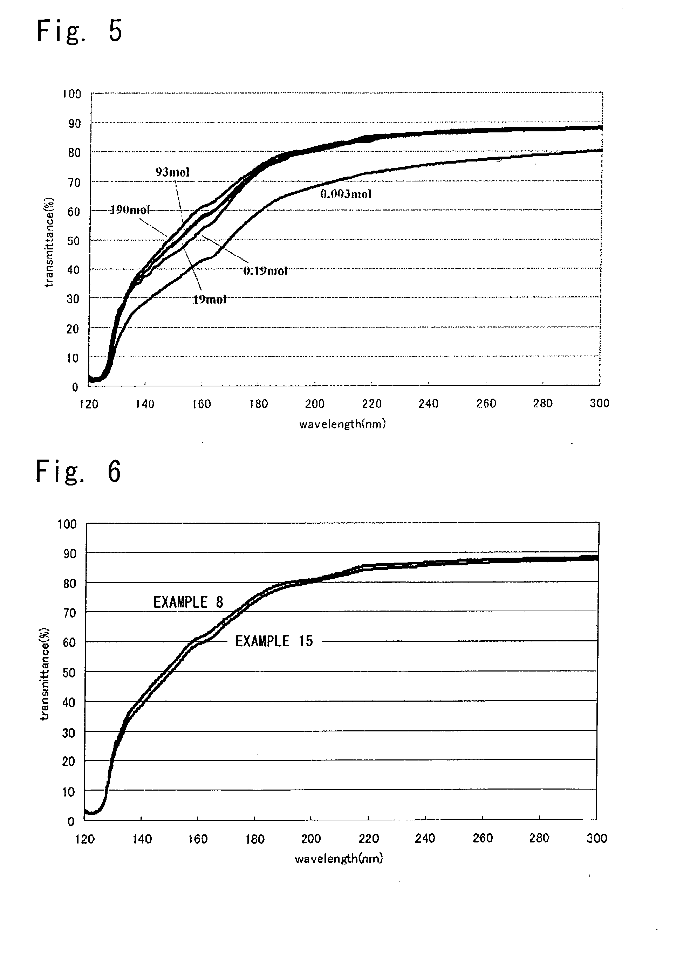

A crystal was grown in the same manner as in Example 8 but introducing a mixed gas of 90% by volume of argon and 10% by volume of carbonyl fluoride instead of the mixed gas of 95% by volume of argon and 5% by volume of carbonyl fluoride in the step of heating in the co-presence of carbonyl fluoride. A sample for measuring the spectra was thus prepared and was measured for its ultraviolet ray transmission factor in vacuum. The result was as shown in Table 1 and Fig. 5.

### Example 12.

A crystal was grown in the same manner as in Example 8 but introducing a mixed gas of 99% by volume of argon and 1% by volume of carbonyl fluoride instead of the mixed gas of 95% by volume of argon and 5% by volume of carbonyl fluoride in the step of heating in the co-presence of carbonyl fluoride. A sample for measuring the spectra was thus prepared and was measured for its ultraviolet ray transmission factor in vacuum. The result was as shown in Table 1 and Fig. 5.

### Example 13.

A crystal was grown in the same manner as in Example 8 but introducing a mixed gas of 99.99% by volume of argon and 0.01% by volume of carbonyl fluoride instead of the mixed gas of 95% by volume of argon and 5% by volume of carbonyl fluoride in the step of heating in the co-presence of carbonyl fluoride. A sample for measuring the spectra was thus prepared and was measured for its ultraviolet ray transmission factor in vacuum. The result was as shown in Table 1 and Fig. 5.

### Example 14.

A crystal was grown in the same manner as in Example 13 but weighing 23.18 g of barium fluoride and 38.57 g of yttrium fluoride to use them as starting materials in the preparatory step of growing crystal. A sample for measuring the spectra was thus prepared and was measured for its ultraviolet ray transmission factor in vacuum. The result was as shown in Table 1 and Fig. 5.

### Example 15.

In this Example, a starting pretreated metal fluoride was prepared, was opened to the atmosphere and was used as a starting material to grow a crystal in the presence of a gaseous scavenger.
The metal fluorides were heated in the co-presence of the carbonyl fluoride in the same manner as in Example 8 and were once cooled down to room temperature to obtain a starting pretreated metal fluoride. The obtained starting pretreated metal fluoride was put again into the crucible 5. The crucible 5 filled with the starting material was set onto an upper part of the after-heater 1, and the heater 2 and the heat-insulating member 3 were set successively to surround them. Next, by using a vacuum exhaust system comprising an oil rotary pump and an oil diffusion pump, the interior of the chamber 6 was evacuated down to 5.0 x 10⁻⁴ Pa. At the same time, heating was conducted by using the high-frequency coil 7 so that the temperature in the crucible was 570° K during the evacuation. Next, a mixed gas of 95% by volume of argon and 5% by volume of methane tetrafluoride was introduced into the chamber 6 until the pressure therein was equal to the atmospheric pressure. Thereafter, the melt was pulled down in the same manner as in the step of growing crystal of Example 1 to grow a crystal. A sample for measuring the spectra was thus prepared and was measured for its ultraviolet ray transmission factor in vacuum. The result was as shown in Table 1 and Fig. 6.

### Example 16.

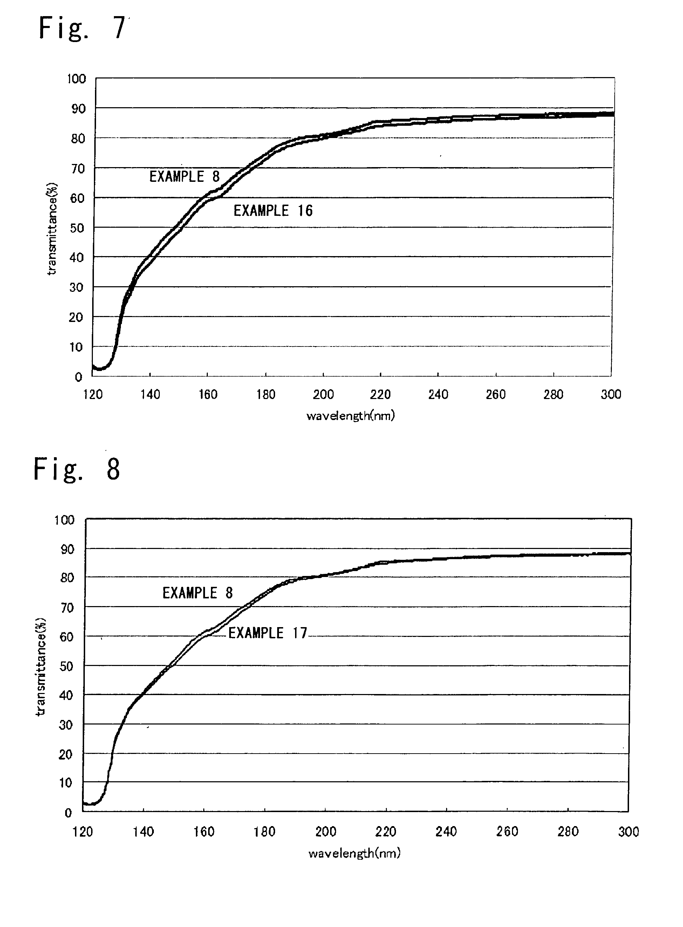

A crystal was grown in the same manner as in Example 8 but introducing a mixed gas of 95% by volume of argon and 5% by volume of methane tetrafluoride instead of the argon gas in the step of exhausting the carbonyl fluoride and introducing the atmosphere gas for growing crystal. A sample for measuring the spectra was thus prepared and was measured for its ultraviolet ray transmission factor in vacuum. The result was as shown in Table 1 and Fig. 7.

### Example 17.

In this Example, a metal fluoride was heated and melted in the presence of carbonyl fluoride, and a crystal was grown from the melt.
The procedure was conducted in the same manner as in Example 1 up to the step of drying the interior of the apparatus by heating. Thereafter, a mixed gas of 95% by volume of argon and 5% by volume of carbonyl fluoride was introduced into the chamber 6 and, by using the high-frequency coil 7, the metal fluoride was melted by so adjusting the output of the high-frequency heating coil that the heating temperature was 1260° K while measuring the temperature at the bottom portion of the crucible. In this state, heating was continued for 2 hours. After heated for 2 hours, the temperature of the starting melt was gradually elevated by adjusting the output of high-frequency waves, and the W-Re wire attached to an end of the pull-down rod 8 was inserted in the hole and was pulled down repetitively. The starting melt could be drawn out from the hole. The output of high-frequency waves was fixed to hold the temperature of this moment, and the starting melt was pulled down to start crystallization. The melt was pulled down continuously for 14 hours at a rate of 3 mm/hr to finally obtain a crystal of a diameter of 2. 1 mm and a length of 40 mm. A sample for measuring the spectra was prepared from the thus obtained crystal and was measured for its ultraviolet ray transmission factor in vacuum. The result was as shown in Table 1 and Fig. 8.

### Example 18.

A crystal was grown in the same manner as in Example 8 but weighing 0.006 g of cerium fluoride, 0.17 g of lithium fluoride and 0.94 g of yttrium fluoride to use them in the preparatory step of growing crystal. A sample for measuring the spectra was prepared and was measured for its ultraviolet ray transmission factor in vacuum. The result was as shown in Table 1 and Fig. 9.

### Comparative Example 1.

A crystal was grown in the same manner as in Example 8 but introducing argon instead of the mixed gas of 95% by volume of argon and 5% by volume of carbonyl fluoride in the step of heating in the co-presence of carbonyl fluoride. A sample for measuring the spectra was prepared and was measured for its ultraviolet ray transmission factor in vacuum. The result was as shown in Table 1 and Figs. 3 and 4.

### Comparative Example 2.

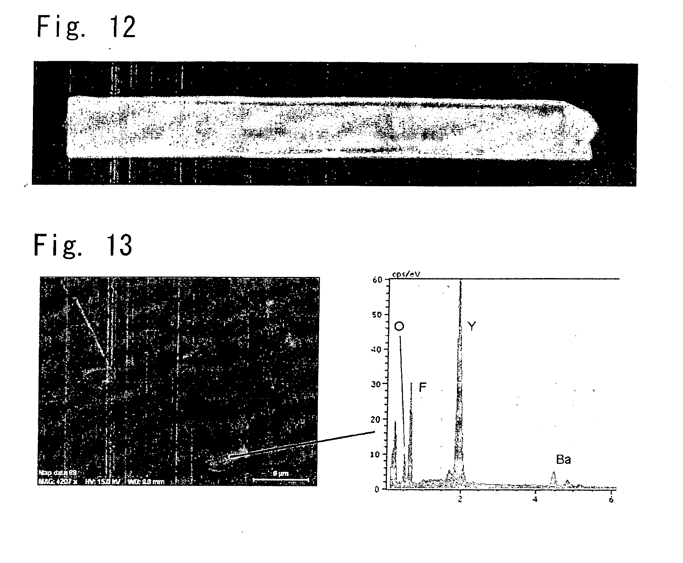

A crystal was grown in the same manner as in Example 8 but introducing a mixed gas of 95% by volume of argon and 5% by volume of methane tetrafluoride instead of the mixed gas of 95% by volume of argon and 5% by volume of carbonyl fluoride in the step of heating in the co-presence of carbonyl fluoride. A sample for measuring the spectra was prepared and was measured for its ultraviolet ray transmission factor in vacuum. The result was as shown in Table 1 and Figs. 3 and 4. Fig. 12 is a photograph of the sample for measuring the spectrum. From a comparison with Fig. 10, it was learned that the crystal was cloudy. The sample for measuring the spectra was, further, observed by using SEM-3400N manufactured by Hitachi, Ltd. The result was as shown in Fig. 13. It was learned that the cloudiness in the crystal was caused by the infiltration of oxygen.

### Comparative Example 3.

A crystal was grown in the same manner as in Example 18 but introducing a mixed gas of 95% by volume of argon and 5% by volume of methane tetrafluoride instead of the mixed gas of 95% by volume of argon and 5% by volume of carbonyl fluoride in the step of heating in the co-presence of carbonyl fluoride. A sample for measuring the spectra was prepared and was measured for its ultraviolet ray transmission factor in vacuum. The result was as shown in Table 1 and Fig. 9.

**Table 1**

| | | COF₂ concentration | | | | |
|---|---|---|---|---|---|---|
| | Mother | (relative to | Time for | Temp. for | Transmittance | Transmittance |
| | crystal | starting materials) | using COF₂ | using COF₂ | (140 nm) | (220 nm) |
| Ex. 1 | BaY2F8 | 93 | 30 min | 790 K | 31% | 73% |
| Ex. 2 | BaY2F8 | 93 | 30 min | 620 K | 15% | 52% |
| Ex. 3 | BaY2F8 | 93 | 30 min | 440 K | 15% | 46% |
| Ex. 4 | BaY2F8 | 93 | 30 min | 350 K | 5% | 39% |
| Ex. 5 | BaY2F8 | 93 | 30 min | 300 K | 5% | 31% |
| Ex. 6 | BaY2F8 | 93 | 30 min | 1260 K | 32% | 77% |
| Ex. 7 | BaY2F8 | 93 | 4 hr | 790 K | 41% | 85% |
| Ex. 8 | BaY2F8 | 93 | 2 hr | 790 K | 38% | 84% |
| Ex. 9 | BaY2F8 | 93 | 10 min | 790 K | 16% | 51% |
| Ex. 10 | BaY2F8 | 93 | 1 min | 790 K | 10% | 36% |
| Ex. 11 | BaY2F8 | 190 | 2 hr | 790 K | 41% | 85% |
| Ex. 12 | BaY2F8 | 19 | 2 hr | 790 K | 40% | 85% |
| Ex. 13 | BaY2F8 | 0.19 | 2 hr | 790 K | 38% | 84% |
| Ex. 14 | BaY2F8 | 0.003 | 2 hr | 790 K | 29% | 73% |
| Ex. 15 | BaY2F8 | 93 | 2 hr | 790 K | 39% | 84% |
| Ex. 16 | BaY2F8 | 93 | 2 hr | 790 K | 39% | 84% |
| Ex. 17 | BaY2F8 | 93 | 2 hr | 1260 K | 41% | 85% |
| Ex. 18 | YLiF4 | 140 | 2 hr | 790 K | 48% | 83% |
| Comp. Ex. 1 | BaY2F8 | - | - | - | 3% | 20% |
| Comp. Ex. 2 | BaY2F8 | - | - | - | 1% | 29% |
| Comp. Ex. 3 | YLiF4 | - | - | - | 4% | 80% |

| | | | | | | |
|---|---|---|---|---|---|---|
| * COF₂ concentration (relative to starting materials) = COF₂ (mols)/total metal fluorides (mols). | | | | | | |

## Claims

1. A method of producing a pretreated metal fluoride by heating a metal fluoride in the co-presence of a carbonyl fluoride.

2. The method of producing a pretreated metal fluoride according to claim 1, wherein the heating temperature is not lower than 300° K but is not higher than 1780° K.

3. The method of producing a pretreated metal fluoride according to claim 1, wherein the amount of the carbonyl fluoride to be made co-present is not less than 1/100 mol per mol of the metal fluoride.

4. A method of producing a fluoride crystal in the co-presence of a carbonyl fluoride by heating and melting a metal fluoride to obtain a melt thereof, and growing a crystal from the melt.

5. A method of producing a fluoride crystal, comprising the step of obtaining a pretreated metal fluoride by heating a metal fluoride in the co-presence of a carbonyl fluoride, andthe step of growing a crystal from the pretreated metal fluoride.

6. The method of producing a fluoride crystal according to claim 5, wherein in the step of obtaining the pretreated metal fluoride, the heating temperature is not lower than 300° K but is not higher than 1780° K.

7. The method of producing a fluoride crystal according to claim 5, wherein in the step of obtaining the pretreated metal fluoride, the amount of the carbonyl fluoride to be made co-present is not less than 1/100 mol per mol of the metal fluoride.

8. The method of producing a fluoride crystal according to claim 5, wherein in the step of growing the crystal, the crystal is grown by a melt pull-up method in which a seed crystal is contacted to the upper end of the melt of the pretreated metal fluoride and is pulled up or by a melt pull-down method in which a pulling-down rod is contacted to the lower end of the melt of the pretreated metal fluoride and is pulled down.

9. The method of producing a fluoride crystal according to claim 8, wherein in the step of growing the crystal, the crystal is grown from the melt in the co-presence of a gaseous scavenger.
